(19) **Europäisches Patentamt**
**European Patent Office**
**Office européen des brevets**

(11) **EP 1 536 566 B1**

(12) **FASCICULE DE BREVET EUROPEEN**

(45) Date de publication et mention
de la délivrance du brevet:
**16.01.2008 Bulletin 2008/03**

(51) Int Cl.:
***H03M 13/05*** *(2006.01)*

(21) Numéro de dépôt: **04364069.7**

(22) Date de dépôt: **15.11.2004**

(54) **Circuit électronique de décodage d'un signal de données asynchrone biphase et procédé de décodage correspondant, dispositif de controle d'un équipement**

Elektronische Schaltung zur Dekodierung eines asynchronen Biphasensignals mit entsprechenden Verfahren und Steuerungsvorrichtung.

Electronic circuit for decoding of an asynchronous biphase signal, corresponding method and corresponding control device.

(84) Etats contractants désignés:
**DE ES GB IT NL**

(30) Priorité: **21.11.2003 FR 0313689**

(43) Date de publication de la demande:
**01.06.2005 Bulletin 2005/22**

(73) Titulaire: **ATMEL NANTES SA**
**44306 Nantes Cédex 3 (FR)**

(72) Inventeurs:
• **Aubree, René**
**44120 Vertou (FR)**
• **Letendu, Raphael**
**44000 Nantes (FR)**

(74) Mandataire: **Vidon, Patrice**
**Cabinet Vidon**
**16 B, rue Jouanet - B.P. 90333**
**Technopole Atalante**
**35703 Rennes Cedex 7 (FR)**

(56) Documents cités:
**EP-A1- 1 347 609        DE-A1- 10 163 702**
**US-A- 5 168 511        US-B1- 6 370 212**

• **HORSTMANN J: "BIPHASE/NRZ DECODER SOLVES JITTER PROBLEMS" EDN ELECTRICAL DESIGN NEWS, CAHNERS PUBLISHING CO. NEWTON, MASSACHUSETTS, US, vol. 28, no. 6, 17 mars 1983 (1983-03-17), page 222,224, XP000763644 ISSN: 0012-7515**

EP 1 536 566 B1

**Description**

**1. Domaine de l'invention**

Le domaine de l'invention est celui du décodage de données numériques.

Plus précisément, l'invention concerne les décodeurs de données asynchrones biphases, en particulier codées selon le code de Manchester.

Plus précisément encore, l'invention concerne la synchronisation de décodeurs de signaux asynchrones biphases.

L'invention peut trouver des applications dans tous les domaines utilisant des transmissions de type Manchester, comme celui du contrôle industriel ou des télécommunications, en particulier lorsqu'il est souhaitable de disposer de décodeurs simples et à coût réduit. Par exemple, l'invention peut s'appliquer à la communication dans le domaine de l'éclairage, et notamment au standard DALI (« Digital Adressable Lighting Interface » ou « Interface d'éclairage numérique adressable »).

**2. Art antérieur**

**2.1. Le codage de Manchester**

Le codage de Manchester est une technique connue depuis longtemps et appliquée dans de nombreux domaines. Il existe plusieurs méthodes pour récupérer l'horloge correspondante dans un récepteur, et en particulier l'utilisation d'une boucle à verrouillage de phase ou d'une horloge précise.

**2.2. Utilisation d'une boucle à verrouillage de phase**

Les décodeurs de trames encodées selon le principe de Manchester nécessitent donc en général l'utilisation d'une boucle à verrouillage de phase, encore appelée PLL (de l'anglais « Phase-Locked Loop ») pour la synchronisation. Selon ce principe, la phase du signal de sortie est verrouillée sur celle du signal d'entrée, ce qui force la fréquence du signal de sortie à se verrouiller sur la fréquence du signal d'entrée, permettant un asservissement de fréquence, donc une synchronisation.

Un inconvénient majeur de cette technique de l'art antérieur est que durant l'étape de verrouillage de phase qui va permettre la synchronisation, les premières données transmises sont perdues.

Un autre inconvénient de cette technique est qu'elle est coûteuse et relativement complexe à mettre en oeuvre, du fait notamment de la présence d'une boucle à verrouillage de phase.

**2.3. Utilisation d'une horloge précise**

Pour d'autres systèmes de transmission à distance, il est nécessaire d'utiliser une horloge précise afin de décoder de manière fiable les données reçues.

Un inconvénient majeur de cette technique est qu'elle impose de connaître au niveau du récepteur la vitesse de la transmission (ou « baud rate »).

Par ailleurs, elle nécessite de disposer d'une horloge locale précise, aussi bien au niveau de l'émetteur qu'au niveau du récepteur, ce qui rend cette technique plus coûteuse et complexe à mettre en oeuvre.

**2.4 autre art antérieur**

La demande de brevet EP 1 347 609 A décrit une méthode de récupération d'horloge et de décodage de codes de Manchester utilisant un compteur alimenté par une horloge interne pour détecter les transition mibit et masquer les transitions initiales, ce qui élimine la nécessité d'utiliser une horloge très précise.

Les documents DE 10 163 702 A, et J. Horstmann, "Biphase/NRZ decoder solves jitter problems", EDN electrical design news, Cahners publishing co., newton, MA/US, vol 28, no 6, 17 mars 1983, pages 222, 224 décrivent également des méthodes de récupération d'horloge pour codes biphase utilisant un compteur alimenté par une horloge interne.

**3. Objectifs de l'invention**

L'invention a notamment pour objectif de pallier ces inconvénients de l'art antérieur.

Plus précisément, un objectif de l'invention est de fournir une technique de décodage d'un signal de données asynchrone biphase permettant de récupérer une horloge de décodage de façon simple et efficace, sans nécessiter de boucle à verrouillage de phase ou d'horloge précise.

Un autre objectif de l'invention est de fournir une telle technique qui permette à un récepteur de s'adapter automatiquement à la vitesse de transmission des données, sans connaissance préalable de cette vitesse.

Encore un autre objectif de l'invention est de générer l'horloge de décodage de manière simple et peu coûteuse.

L'invention a encore pour objectif de mettre en oeuvre une telle technique de décodage qui soit particulièrement robuste.

**4. Caractéristiques essentielles de l'invention**

Ces objectifs, ainsi que d'autres qui apparaîtront par la suite, sont atteints à l'aide d'un circuit électronique de décodage d'un signal de données asynchrone biphase.

Selon l'invention, un tel circuit comprend des moyens de génération d'une horloge de décodage mettant en oeuvre un compteur alimenté par une horloge interne, et répétant des cycles comprenant une incrémentation du compteur jusqu'à la détection d'une transition dans le signal de données, puis une décrémentation du compteur jusqu'à zéro.

Ainsi, l'invention concerne un circuit électronique de décodage qui permet de récupérer en sortie les données transmises et leur horloge de transmission à l'aide d'un simple compteur et cela sans nécessiter d'horloge interne précise.

Un tel circuit va s'adapter automatiquement à la vitesse de transmission des données, sans nécessiter une connaissance précise de l'horloge locale.

On peut alors assimiler la valeur de comptage en sortie du compteur à un signal en dents de scie, les pics de chacune des dents correspondant aux transitions dans le signal de données. C'est à partir de ces transitions que l'on va récupérer l'horloge de décodage et les données décodées.

Ainsi, l'invention s'avère particulièrement efficace et peu complexe et repose sur une approche tout à fait nouvelle et inventive du décodage de trame asynchrone biphase à l'aide d'un simple compteur.

De façon préférentielle, l'horloge de décodage est générée par la prise en compte de chaque pic d'un signal représentatif du contenu du compteur.

Notamment, chaque pic est utilisé pour repérer une transition qui transporte la valeur d'un bit du signal de données.

Dans ce cas, on va analyser le sens de chacune des transitions pour décoder la valeur d'un bit.

Par décodage du sens de la transition, le circuit permet ainsi à la fois de déterminer la valeur d'un bit du signal de données et de reconstituer une horloge permettant de paralléliser les données décodées.

Selon un mode de réalisation avantageux, le circuit électronique comprend au moins un registre de mémorisation du contenu du compteur lors de la détection d'une transition dans le signal de données.

Ce registre va permettre d'améliorer la robustesse du circuit électronique de l'invention en comparant la sortie du compteur à la valeur stockée dans ce registre.

Préférentiellement, le circuit électronique comprend des moyens d'initialisation qui, lors du premier front descendant, activent l'incrémentation du compteur, ce dernier étant préalablement forcé à zéro.

De façon avantageuse, le circuit électronique comprend des moyens de fenêtrage limitant la détection d'une transition sur des intervalles prédéterminés.

Dans ce cas, chacun des intervalles prédéterminés couvre environ 50% d'un temps binaire et est centré sur chacune des transitions.

On considère ici qu'un temps binaire correspond à la durée (ou à la largeur) d'un bit.

Notamment, l'intervalle prédéterminé est contrôlé par un premier comparateur alimenté par la sortie du registre de mémorisation divisée par deux et par le compteur.

Ainsi, lorsque la valeur du compteur est supérieure à la valeur du registre de mémorisation divisée par deux, une fenêtre d'autorisation de détection de front est créée, correspondant à cet intervalle prédéterminé.

Selon un autre aspect avantageux de l'invention, le circuit électronique comprend des moyens de détection de l'interruption du signal de données.

Notamment ces moyens de détection de l'interruption comprennent un deuxième comparateur alimenté par la sortie du registre de mémorisation multipliée par deux et par le compteur.

Ainsi, on peut déterminer si la transmission n'est pas interrompue, en vérifiant que l'on reçoit toujours des transitions.

La robustesse du système est ainsi améliorée en réduisant la probabilité de fausse détection et en interdisant la détection sur les fronts inter-bits lorsque les bits consécutifs sont de même valeur à l'aide du premier comparateur, et/ou en détectant les absences de transmission à l'aide du deuxième comparateur.

Préférentiellement, le circuit électronique comprend des moyens de réjection des parasites sur le signal de données.

Notamment ces moyens de réjection comprennent un filtre numérique alimenté par le signal de données et contrôlé par l'horloge interne.

En particulier, ces moyens de réjection peuvent prendre en compte au moins trois échantillons successifs pour décider l'existence d'une transition.

Ces moyens de réjection permettent au décodeur d'éviter la confusion entre un parasite et une transition.

De façon avantageuse, l'horloge interne est de fréquence au moins supérieure à 16 fois le débit du signal de données, ce qui permet de paralléliser les données en sortie du décodeur.

Selon un mode avantageux de réalisation de l'invention, le signal de données est encodé selon un codage de Manchester.

On utilise ainsi un codage par transition, où les bits sont encodés par des transitions et non par des états.

Préférentiellement, le signal de données est organisé en trames successives débutant chacune par un bit de démarrage.

Selon un mode de réalisation avantageux, le circuit électronique permet de recevoir et de décoder une séquence comprenant un nombre non défini de données.

Ainsi, le circuit s'adapte automatiquement à chaque séquence qu'il reçoit, même si la longueur des séquences varie au cours de la transmission.

L'invention concerne également un procédé de décodage d'une trame de données asynchrone biphase, comprenant des étapes de génération d'une horloge de décodage mettant en oeuvre un compteur alimenté par une horloge interne, et répétant des cycles comprenant une incrémentation du compteur jusqu'à la détection d'une transition dans le signal de données, puis une décrémentation du compteur jusqu'à zéro.

L'invention concerne encore les dispositifs de contrôle d'au moins un équipement mettant en oeuvre au moins un circuit électronique tel que décrit précédemment.

Notamment, l'équipement contrôlé par ces dispositifs de contrôle peut être un éclairage.

**5. Liste des figures**

D'autres caractéristiques et avantages de l'invention apparaîtront plus clairement à la lecture de la description suivante d'un mode de réalisation préférentiel, donné à titre de simple exemple illustratif et non limitatif, et des dessins annexés, parmi lesquels :

- la figure 1 présente un schéma général d'un décodeur d'un signal encodé selon le principe de Manchester ;
- la figure 2 illustre une trame de données asynchrone biphase (Manchester) reçue par le décodeur de la figure 1 ;
- la figure 3 décrit le fonctionnement du décodeur de la figure 1, selon l'invention, sous la forme d'un schéma-bloc ;
- la figure 4 présente un chronogramme des différents signaux d'entrée/sortie et des signaux intermédiaires du schéma de la figure 3.

**6. Description d'un mode de réalisation de l'invention**

Le principe général de l'invention repose sur un circuit électronique de décodage de trame asynchrone biphase permettant de récupérer en sortie les données transmises et leur horloge de transmission à l'aide d'un simple compteur et cela sans nécessiter d'horloge interne précise ou de boucle à verrouillage de phase.

Ce circuit électronique peut en particulier s'adapter automatiquement à une vitesse de transmission quelconque et variable, même s'il ne connaît pas précisément l'horloge interne. Il suffit pour cela de mettre en oeuvre un compteur suffisamment profond pour s'adapter à une vitesse de transmission relativement basse, et une l'horloge locale suffisamment rapide par rapport à une vitesse de transmission plus élevée.

On considère selon l'invention que la trame de données reçue au niveau du décodeur est de type asynchrone car elle est constituée d'une suite d'éléments binaires asynchrones du récepteur. Elle est également de type biphase car les bits de données ne sont pas encodés par des états mais par des bits de transition. Ce codage est connu sous le nom de codage Manchester.

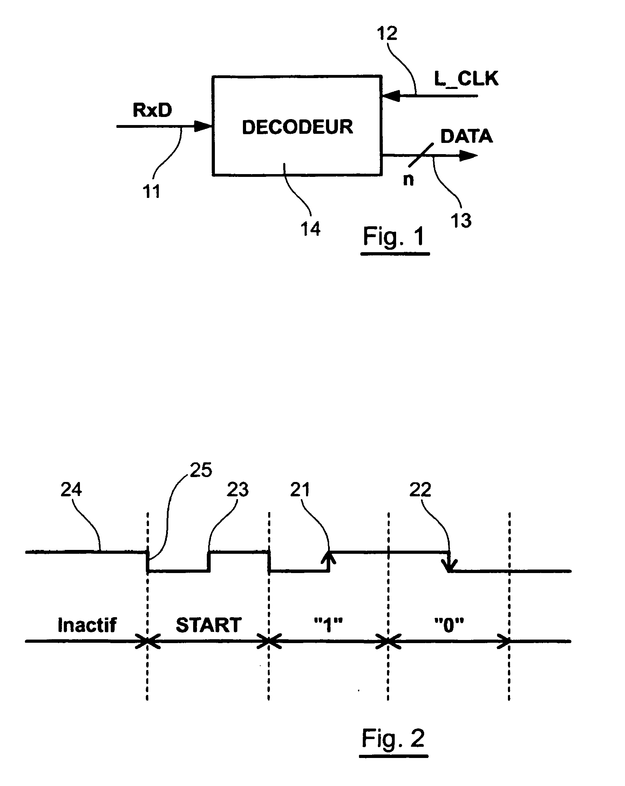

On présente, en relation avec la figure 1, les entrées et les sorties du décodeur 14.

Ce décodeur 14 possède deux entrées, la première 11 sur laquelle sont envoyées les trames asynchrones biphases (notées RxD sur la figure) et la seconde 12 correspondant à l'entrée de l'horloge locale (L_CLK sur la figure), encore appelée horloge interne. Dans le mode de réalisation décrit, l'horloge locale peut être de fréquence imprécise, mais supérieure à 16 fois le débit de la donnée à décoder.

Ce décodeur 14 possède également une sortie 13 qui permet de retrouver les données décodées DATA, mises en parallèle sur une largeur de $n$ bits, le nombre $n$ variant suivant l'application.

Dans le mode de réalisation décrit, le signal transmis est organisé en trames. Les trames asynchrones biphases reçues sur l'entrée RxD 11 du décodeur 14 se composent d'un bit de démarrage (appelé bit de « start »), se poursuivent par des bits de données et se terminent par un ou plusieurs bit d'arrêt. Ces différents bits ne sont pas encodés par des états mais par des transitions, comme illustré en figure 2.

Ainsi, selon le codage de Manchester, les bits égaux à '1' sont codés par des fronts montants 21 et les bits égaux à '0' sont codés par des fronts descendants 22. Le bit de start 23 est également encodé selon le principe de Manchester.

Il est bien entendu que l'invention présentée s'applique également à tout autre type de codage où les bits sont encodés par des transitions et non par des états. On pourra ainsi, dans un autre mode de réalisation, coder les bits égaux à '1' par des fronts descendants et les bits égaux à '0' par des fronts montants.

En l'absence de transmission ou entre les données, on reste dans un état inactif 24, durant lequel il n'y a aucune transition.

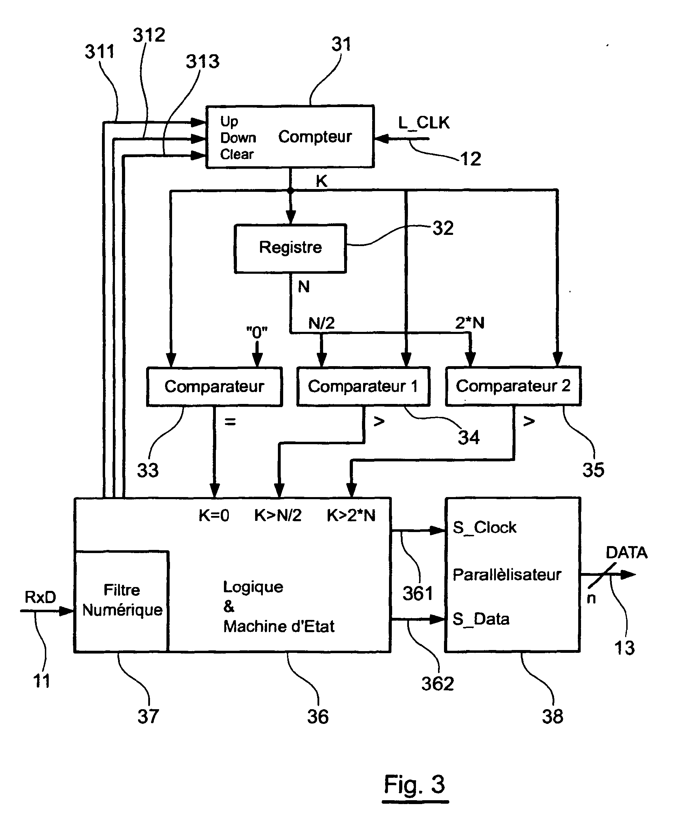

On présente plus précisément, en relation avec la figure 3, le schéma-bloc du décodeur 14.

Dans un mode préférentiel de réalisation, ce décodeur 14 est composé :

- d'un compteur 31, pouvant être incrémenté ou décrémenté ;
- d'un registre 32 servant à stocker la valeur du compteur 31 à un instant donné;
- d'un comparateur 33 comparant la valeur du compteur 31 à zéro, appelé comparateur à zéro ;
- de deux autres comparateurs appelés premier comparateur 34 et deuxième comparateur 35 ;
- d'un bloc « Logique et Machine d'Etat » 36 ;
- d'un filtre numérique 37 ;
- et d'un parallélisateur 38.

De manière à améliorer le décodage, il est souhaitable de placer un filtre numérique 37 à l'entrée du montage. Ce filtre 37 va permettre la réjection des parasites, en évitant au décodeur 14 de confondre un parasite avec une transition. Pour cela, on peut prendre en compte plusieurs échantillons successifs de signal, par exemple trois : en fonction du niveau de ces trois échantillons successifs, on pourra décider s'ils correspondent à une transition (front montant ou front descendant) ou à un parasite.

Durant l'état inactif 24, le compteur 31 est maintenu à la valeur zéro. Le comparateur à zéro 33 comparant la sortie du compteur 31 à la valeur zéro est donc en position 'vrai', et cette information est transmise au bloc « Logique et Machine d'Etat » 36. Rien ne se passe :

la ligne de transmission est dans un état inactif. Dans cette position, le compteur 31 est à zéro, sous l'action d'une commande de mise à zéro 313 (appelée « clear »).

Lors du premier front descendant 25, le compteur 31 reçoit une commande 311 du bloc « Logique et Machine d'Etat » 36, lançant une incrémentation (sens « up », ou montant) jusqu'à la détection d'une transition dans le signal de données. La valeur K du compteur 31 est alors stockée dans le registre 32 et le compteur 31 repart dans l'autre sens : lorsque le bloc « Logique et Machine d'Etat » 36 détecte une transition, il envoie une commande de décrémentation 312 (sens « down » ou descendant).

Lorsque le comparateur à zéro 33 détecte que le compteur 31 a atteint la valeur zéro, ce dernier repart de nouveau dans le sens up, sous l'action par exemple de la logique définie dans le bloc « Logique et Machine d'Etat » 36.

A la prochaine transition, la nouvelle valeur du compteur 31 est mémorisée dans le registre 32 et le compteur 31 est de nouveau décrémenté.

Dans ce mode préférentiel de réalisation décrit, le circuit comprend également deux autres comparateurs 34 et 35 permettant d'améliorer les performances de décodage.

Le premier comparateur 34 permet de comparer la valeur du compteur 31 à la valeur N du registre 32 divisée par deux. Lorsque la valeur du compteur 31 est supérieure à la valeur N du registre 32 divisée par deux (N/2), une fenêtre est créée, autorisant la détection de transition dans cette fenêtre. Une telle fenêtre couvre environ 50% d'un temps binaire et est centrée sur la transition.

Ce premier comparateur 34 permet donc d'améliorer la robustesse du système puisqu'il réduit la probabilité de fausse détection et interdit la détection sur les fronts inter-bits lorsque les bits consécutifs sont de même valeur.

Le deuxième comparateur 35 permet de comparer la valeur du compteur 31 à la valeur N du registre 32 multipliée par deux. Cette comparaison permet de détecter si on reçoit toujours des transitions, et donc si la transmission n'est pas interrompue. La robustesse du décodeur est donc de nouveau améliorée.

Finalement, dans ce mode de réalisation décrit, le bloc « Logique et Machine d'Etat » 36 va permettre de récupérer deux signaux, un signal d'horloge de décodage 361 et un signal de données décodées intermédiaire 362, appelés S_Clock et S_Data sur le schéma-bloc.

Ce bloc « Logique et Machine d'Etat » 36 intervient à différentes étapes au cours du décodage : il a pour rôle de détecter les changements de fronts sur le signal de données asynchrone biphase à décoder, de compter le nombre de bits reçus suivant l'application et de gérer le compteur 31 et le registre 32 en tenant compte de la sortie des trois comparateurs 33, 34 et 35.

Un dernier bloc parallélisateur 38 permet de reconstruire le signal de données décodées 13 DATA, constitué des données décodées en parallèle sur une largeur *n* bits, ou le nombre *n* dépend de l'application.

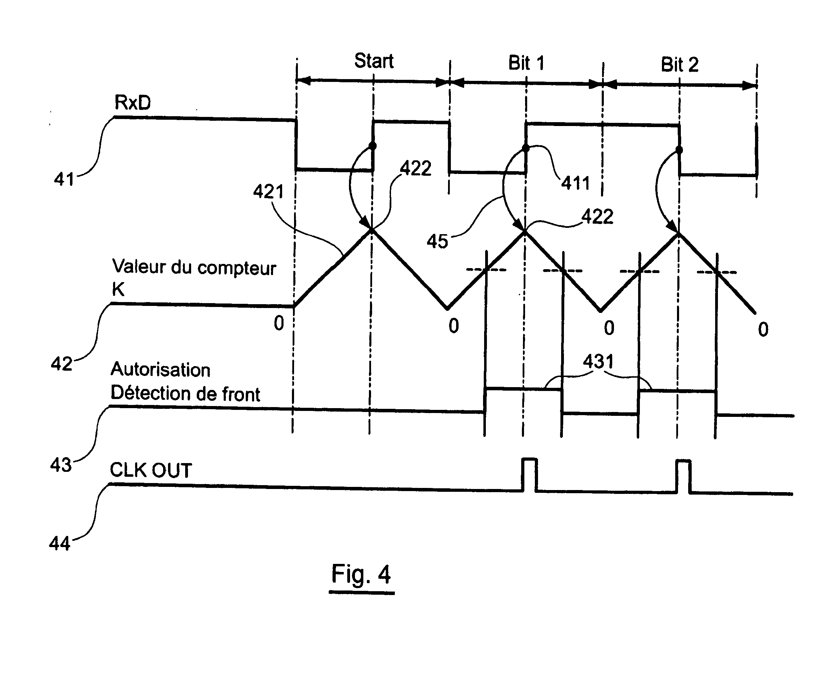

La figure 4 permet de visualiser plus facilement le fonctionnement du décodeur 14, et plus particulièrement celui du compteur 31. Certains signaux du mode de réalisation préférentiel décrit ci-dessus sont représentés sur ce chronogramme, en fonction d'une trame de données asynchrone biphase 41 reçue, composée d'un bit de start et de bits de données, similaires au signal de la figure 2.

La valeur de comptage en sortie du compteur 31 peut être assimilé à un signal 42 en dents de scie 421. Ces dents de scie 421 ne sont pas forcément régulières car le rapport cyclique peut être différent de 50%.

A chaque pic 422 du signal en dents de scie correspond (45) une transition 411 qui transporte la valeur d'un bit sur le signal de données. C'est en décodant le sens de la transition que le décodeur tel que décrit va retrouver la valeur du bit et reconstituer une horloge 44 pour paralléliser la donnée.

La troisième courbe 43 représente les fenêtres 431 déterminées à l'aide du premier comparateur 34. Ce sont ces fenêtres 431 qui donnent l'autorisation de détection d'un front dans l'intervalle qu'elles définissent. C'est au moyen de ces intervalles prédéterminés et du signal 42 en dents de scie du compteur 31 que l'on peut récupérer l'horloge de décodage 361 (également représentée par la quatrième courbe 44) et les données décodées.

Dans un mode de réalisation particulier, le circuit électronique de l'invention permet également de décoder une séquence non figée de données. En effet, comme expliqué ci-dessus, l'analyse de chaque fenêtre 431 nous indique la présence ou non d'une transition dans cette fenêtre. Dans le cas où l'on vient de détecter une série de M transitions, on va analyser le contenu de la fenêtre suivante d'autorisation de détection d'un front : s'il n'y a pas de transition dans cette fenêtre, on peut considérer que le dernier bit reçu (bit M) est un bit de stop. Sinon, on doit s'attendre à recevoir d'autres données.

Supposons par exemple que le décodeur peut recevoir plusieurs trames de 16 ou de 17 bits, sans savoir à l'avance dans quel ordre il va les recevoir. Dans ce cas, le circuit électronique de décodage va d'abord décoder les 16 premiers bits reçus, comme décrit précédemment. Ne sachant pas exactement le nombre de données qu'il doit recevoir, le décodeur va continuer à étudier la séquence reçue, après réception et décodage des 16 premiers bits.

Il va donc continuer à analyser le contenu de la nouvelle fenêtre d'autorisation de détection de transition, créée après réception des 16 premiers bits. Si la nouvelle fenêtre contient une transition, on considère que cette transition correspond au 17$^{\text{ème}}$ bit. On décide donc qu'on a reçu une trame de 17 bits. Par contre, si le contenu de la nouvelle fenêtre est vide, on doit considérer que la dernière transition reçue correspondait à un bit de stop et que par conséquent la trame reçue était composée de 16 bits.

Il est bien entendu que ce mode de réalisation particulier n'est pas restreint aux trames de 16 et de 17 bits, et que l'Homme du Métier pourra l'étendre facilement à des trames de longueurs différentes.

Le décodeur selon l'invention permet donc de recevoir et de traiter des trames comprenant un nombre non figé de données.

En général, la largeur du compteur et du registre est donnée par le rapport entre le « baud rate » du signal de données et la valeur de l'horloge locale.

Par exemple, avec une donnée à 1200 bauds et une horloge locale à 1MHz, la capacité de comptage doit être supérieure à $\frac{10^6}{2400}$, , soit 416, ce qui définit un compteur à 9 bits. Pour permettre d'absorber les tolérances sur la donnée et sur l'horloge locale ($\pm$ 10% par exemple) et mettre en place la détection d'erreurs de trame, l'utilisation d'un compteur d'au moins 10 bits est recommandée.

Ce circuit électronique de décodage peut notamment être mis en oeuvre pour le décodage de trames de type DALI. Il pourra donc être utilisé, par exemple, dans un dispositif de contrôle de l'éclairage.

## Revendications

1. Circuit électronique de décodage d'un signal de données asynchrone biphase,
   comprenant des moyens de génération d'une horloge de décodage mettant en oeuvre un compteur alimenté par une horloge interne, et répétant des cycles comprenant une incrémentation dudit compteur jusqu'à la détection d'une transition dans ledit signal de données, **caractérisé en ce qu'**il comprend des moyens aptes à faire suivre à ladite incrémentation une décrémentation dudit compteur jusqu'à zéro.

2. Circuit électronique selon la revendication 1, **caractérisé en ce que** ladite horloge de décodage est générée par la prise en compte de chaque pic d'un signal représentatif du contenu dudit compteur.

3. Circuit électronique selon la revendication 2, **caractérisé en ce que** chacun desdits pics est utilisé pour repérer une transition qui transporte la valeur d'un bit dudit signal de données.

4. Circuit électronique selon la revendication 3, **caractérisé en ce que** le sens de chacune desdites transitions est analysé pour décoder la valeur d'un bit dudit signal de données.

5. Circuit électronique selon l'une quelconque des revendications 1 à 4, **caractérisé en ce qu'**il comprend au moins un registre de mémorisation du contenu dudit compteur lors de ladite détection d'une transition dans ledit signal de données.

6. Circuit électronique selon l'une quelconque des revendications 1 à 5, **caractérisé en ce qu'**il comprend des moyens d'initialisation qui, lors du premier front descendant, activent l'incrémentation dudit compteur préalablement forcé à zéro.

7. Circuit électronique selon l'une quelconque des revendications 1 à 6, **caractérisé en ce qu'**il comprend des moyens de fenêtrage limitant ladite détection d'une transition sur des intervalles prédéterminés.

8. Circuit électronique selon la revendication 7, **caractérisé en ce que** chacun desdits intervalles prédéterminés couvre environ 50% d'un temps binaire et est centré sur lesdites transitions.

9. Circuit électronique selon l'une quelconque des revendications 7 et 8, **caractérisé en ce que** ledit intervalle prédéterminé est contrôlé par un premier comparateur alimenté par la sortie du registre de mémorisation divisée par deux et par ledit compteur.

10. Circuit électronique selon l'une quelconque des revendications 1 à 9, **caractérisé en ce qu'**il comprend des moyens de détection de l'interruption dudit signal de données.

11. Circuit électronique selon la revendication 10, **caractérisé en ce que** lesdits moyens de détection de l'interruption comprennent un deuxième comparateur alimenté par la sortie du registre de mémorisation multipliée par deux et par ledit compteur.

12. Circuit électronique selon l'une quelconque des revendications 1 à 11, **caractérisé en ce qu'**il comprend des moyens de réjection des parasites sur ledit signal de données.

13. Circuit électronique selon la revendication 12, **caractérisé en ce que** lesdits moyens de réjection comprennent un filtre numérique alimenté par ledit signal de données et contrôlé par ladite horloge interne.

14. Circuit électronique selon l'une quelconque des revendications 12 et 13, **caractérisé en ce que** lesdits moyens de réjection prennent en compte au moins trois échantillons successifs pour décider l'existence d'une desdites transitions.

15. Circuit électronique selon l'une quelconque des revendications 1 à 14, **caractérisé en ce que** ladite horloge interne est de fréquence au moins supérieure à 16 fois le débit dudit signal de données.

16. Circuit électronique selon l'une quelconque des revendications 1 à 15 **caractérisée en ce que** ledit signal de données est encodé selon un codage de Manchester.

17. Circuit électronique selon l'une quelconque des revendications 1 à 16, **caractérisé en ce que** ledit signal de données est organisé en trames successives débutant chacune par un bit de démarrage.

18. Circuit électronique selon l'une quelconque des revendications 1 à 17, **caractérisé en ce qu'**il permet de recevoir et de décoder une séquence comprenant un nombre non défini de données.

19. Procédé de décodage d'une trame de données asynchrone biphase, comprenant des étapes de génération d'une horloge de décodage mettant en oeuvre un compteur alimenté par une horloge interne, et répétant des cycles comprenant une incrémentation dudit compteur jusqu'à la détection d'une transition dans ledit signal de donnée, **caractérisé en ce que** chaque cycle comprend une décrémentation dudit compteur jusqu'à zéro après ladite incrémentation.

20. Dispositif de contrôle d'au moins un équipement, comprenant un circuit électronique de décodage d'un signal de données asynchrone biphase, comprenant lui-même des moyens de génération d'une horloge de décodage mettant en oeuvre un compteur alimenté par une horloge interne, et répétant des cycles comprenant une incrémentation dudit compteur jusqu'à la détection d'une transition dans ledit signal de données, **caractérisé en ce qu'**il comprend, des moyens aptes à faire suivre à ladite incrémentation une décrémentation dudit compteur jusqu'à zéro.

21. Dispositif de contrôle selon la revendication 20, **caractérisé en ce que** ledit équipement est un éclairage.


**Claims**

1. Electronic circuit for decoding an asynchronous two-phase data signal,
   comprising means for generating a decoding clock using a counter fed by an internal clock, and repeating cycles including incrementation of the counter until detection of a transition in the data signal, **characterised in that** it comprises means capable to do the incrementation follow a decrementation of the counter down to zero.

2. Electronic circuit according to claim 1, **characterised in that** the decoding clock is generated by taking into account each peak of a signal representative of the contents of the counter.

3. Electronic circuit according to claim 2, **characterised in that** each of the peaks is used to mark a transition that transports the value of a bit of the data signal.

4. Electronic circuit according to claim 3, **characterised in that** the direction of each of the transitions is analysed to decode the value of a bit of the data signal.

5. Electronic circuit according to any of claims 1 to 4, **characterised in that** it comprises at least one register for memorising the contents of the counter when the detection of a transition occurs in the data signal.

6. Electronic circuit according to any of claims 1 to 5, **characterised in that** it comprises initialisation means which, during the first falling front, activate incrementation of the counter, the counter being forced to zero before starting.

7. Electronic circuit according to any of claims 1 to 6, **characterised in that** it comprises windowing means limiting the detection of a transition on predetermined intervals.

8. Electronic circuit according to claim 7, **characterised in that** each of the predetermined intervals covers approximately 50% of a binary time and is centred on the transitions.

9. Electronic circuit according to any of claims 7 and 8, **characterised in that** the predetermined interval is controlled by a first comparator fed by the output from the memory register divided by two, and by the counter.

10. Electronic circuit according to any of claims 1 to 9, **characterised in that** it comprises means for detecting interruption of the data signal.

11. Electronic circuit according to claim 10, **characterised in that** the interruption detection means include a second comparator fed by the output from the memory register multiplied by two, and by the counter.

12. Electronic circuit according to any of claims 1 to 11, **characterised in that** it comprises means for rejecting parasites on the data signal.

13. Electronic circuit according to claim 12, **characterised in that** the rejection means include a digital filter fed by the data signal and controlled by the internal clock.

**14.** Electronic circuit according to any of claims 12 and 13, **characterised in that** the rejection means use at least three successive samples to decide on whether or not one of the transitions exists.

**15.** Electronic circuit according to any of claims 1 to 14, **characterised in that** the internal clock has a frequency at least 16 times greater than the data signal rate.

**16.** Electronic circuit according to any of claims 1 to 15, **characterised in that** the data signal is encoded using Manchester encoding.

**17.** Electronic circuit according to any of claims 1 to 16, **characterised in that** the data signal is organised into successive frames each beginning with a start bit.

**18.** Electronic circuit according to any of claims 1 to 17, **characterised in that** it can receive and decode a sequence comprising an undefined number of data.

**19.** Method for decoding a two-phase asynchronous data frame,
comprising steps for generating a decoding clock using a counter fed by an internal clock, and repeating cycles including incrementation of the counter until detection of a transition in the data signal, **characterised in that** each cycle comprises a decrementation of the counter down to zero following the incrementation.

**20.** Control device of at least one equipment,
comprising an electronic circuit for decoding a two-phase asynchronous data signal, comprising itself means for generating a decoding clock using a counter fed by an internal clock, and repeating cycles including incrementation of the counter until detection of a transition in the data signal, **characterised in that** it comprises means capable to do the incrementation follow a decrementation of the counter down to zero.

**21.** Control device according to claim 20, **characterised in that** the equipment is a lighting equipment.


**Patentansprüche**

**1.** Elektronische Schaltung zum Dekodieren eines zweiphasigen asynchronen Datensignals,
welche Mittel zum Erzeugen eines Dekodiertakts umfasst, der einen von einem internen Takt gespeisten Zähler einsetzt und Zyklen wiederholt, die ein Inkrement des Zählers umfassen, bis zum Erfassen eines Übergangs in dem Datensignal,
**dadurch gekennzeichnet, dass** die Schaltung Mittel umfasst, die in der Lage sind, der Inkrementierung eine Dekrementierung des Zählers auf Null folgen zu lassen.

**2.** Elektronische Schaltung nach Anspruch 1, **dadurch gekennzeichnet, dass** der Dekodiertakt durch das Berücksichtigen einer jeden Spitze eines Signals erzeugt wird, welches für den Inhalt des Zählers repräsentativ ist.

**3.** Elektronische Schaltung nach Anspruch 2, **dadurch gekennzeichnet, dass** jede der Spitzen dazu verwendet wird, einen Übergang zu erfassen, der den Wert eines Bits des Datensignals befördert.

**4.** Elektronische Schaltung nach Anspruch 3, **dadurch gekennzeichnet, dass** die Richtung jeder dieser Übergänge analysiert wird, um den Wert eines Bits des Datensignals zu dekodieren.

**5.** Elektronische Schaltung nach einem der Ansprüche 1 bis 4, **dadurch gekennzeichnet, dass** die Schaltung mindestens ein Register zum Speichern des Inhalts des Zählers beim Erfassen eines Übergangs in dem Datensignal umfasst.

**6.** Elektronische Schaltung nach einem der Ansprüche 1 bis 5, **dadurch gekennzeichnet, dass** die Schaltung Mittel zum Initialisieren umfasst, die bei der ersten Abfallflanke die Inkrementierung des vorher auf den Wert Null gezwungenen Zählers aktivieren.

**7.** Elektronische Schaltung nach einem der Ansprüche 1 bis 6, **dadurch gekennzeichnet, dass** die Schaltung Mittel zur Fensteranordnung umfasst, welche die Erfassung eines Übergangs über vorgegebene Intervalle begrenzt.

**8.** Elektronische Schaltung nach Anspruch 7, **dadurch gekennzeichnet, dass** jedes der vorgegebenen Intervalle etwa 50 % einer binären Zeit abdeckt und um die Übergänge zentriert ist.

**9.** Elektronische Schaltung nach einem der Ansprüche 7 oder 8, **dadurch gekennzeichnet, dass** das vorgegebene Intervall von einem ersten Komparator gesteuert wird, der vom Ausgang des durch zwei dividierten Speicherregisters und des Zählers gespeist wird.

**10.** Elektronische Schaltung nach einem der Ansprüche 1 bis 9 **dadurch gekennzeichnet, dass** die Schaltung Mittel zum Erfassen der Unterbrechung des Datensignals umfasst.

**11.** Elektronische Schaltung nach Anspruch 10, **dadurch gekennzeichnet, dass** die Mittel zum Erfassen der Unterbrechung einen zweiten Komparator umfassen, der vom Ausgang des um zwei multiplizierten Speicherregisters und von dem Zähler gespeist wird.

**12.** Elektronische Schaltung nach einem der Ansprüche 1 bis 11, **dadurch gekennzeichnet, dass** die Schaltung Mittel zum Unterdrücken von Störungen des Datensignals umfasst.

**13.** Elektronische Schaltung nach Anspruch 12, **dadurch gekennzeichnet, dass** die Mittel zum Unterdrücken ein numerisches Filter umfassen, das von dem Datensignal gespeist und von dem internen Takt gesteuert wird.

**14.** Elektronische Schaltung nach einem der Ansprüche 12 oder 13, **dadurch gekennzeichnet, dass** die Mittel zum Unterdrücken mindestens drei aufeinander folgende abgetastete Werte berücksichtigen, um über die Existenz einer der Übergänge zu entscheiden.

**15.** Elektronische Schaltung nach einem der Ansprüche 1 bis 14, **dadurch gekennzeichnet, dass** die Frequenz des internen Taktes einen Wert aufweist, der mindestens mehr als 16 Mal den Durchsatz des Datensignals beträgt.

**16.** Elektronische Schaltung nach einem der Ansprüche 1 bis 15, **dadurch gekennzeichnet, dass** das Datensignal nach einer Manchester-Kodierung kodiert ist.

**17.** Elektronische Schaltung nach einem der Ansprüche 1 bis 16, **dadurch gekennzeichnet, dass** das Datensignal nach aufeinander folgenden Rastern organisiert ist, die jeweils mit einem Startbit anfangen.

**18.** Elektronische Schaltung nach einem der Ansprüche 1 bis 17, **dadurch gekennzeichnet, dass** die Schaltung den Empfang und das Dekodieren einer Folge ermöglicht, die eine nicht definierte Zahl von Daten umfasst.

**19.** Verfahren zum Dekodieren eines asynchronen, zweiphasigen Datenrasters, welches Schritte zum Erzeugen eines Dekodiertaktes umfasst, die einen von einem internen Takt gespeisten Zähler einsetzt und Zyklen wiederholt, die eine Inkrementierung des Zähler bis zum Erfassen eines Übergangs in dem Datensignal umfasst,
**dadurch gekennzeichnet, dass** jeder Zyklus nach der Inkrementierung eine Dekrementierung des benannten Zählers auf Null umfasst.

**20.** Steuervorrichtung von mindestens einer Anlage, die eine elektronische Schaltung zum Dekodieren eines asynchronen, zweiphasigen Datensignals umfasst, welches selbst Mittel zum Erzeugen eines Dekodiertaktes umfasst, die einen von einem internen Takt gespeisten Zähler einsetzt und Zyklen wiederholt, die eine Inkrementierung dieses Zählers bis zum Erfassen eines Übergangs in dem Datensignal umfasst,
**dadurch gekennzeichnet, dass** es Mittel umfasst, die in der Lage sind, der Inkrementierung eine Dekrementierung des Zählers auf Null folgen zu lassen.

**21.** Steuervorrichtung nach Anspruch 20, **dadurch gekennzeichnet, dass** es sich bei der Anlage um eine Beleuchtung handelt.

Fig. 1

Inactif    START    "1"    "0"

Fig. 2

Fig. 3

Fig. 4

EP 1 536 566 B1

EP 1 536 566 B1

RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1347609 A

- DE 10163702 A

**Littérature non-brevet citée dans la description**

- Biphase/NRZ decoder solves jitter problems. **J. HORSTMANN.** EDN electrical design news. Cahners publishing co, 17 Mars 1983, vol. 28, 222, 224